# EUROPÄISCHE PATENTSCHRIFT

(11) **EP 2 524 088 B1**
(45) Veröffentlichungstag und Bekanntmachung des Hinweises auf die Patenterteilung: **25.12.2013**
(21) Anmeldenummer: 10776110.8
(22) Anmeldetag: 12.11.2010
(51) Int. Cl.: E03D 9/03, A61L 9/14, B05B 17/06

(54) **ABGABEVORRICHTUNG MIT PIEZO-ELEKTRISCHEM ELEMENT**
DISPENSER WITH PIEZO-ELECTRIC UNIT
DISTRIBUTEUR AVEC ORGAN PIEZOELECTRIQUE

(30) Priorität: 09.04.2010 DE 102010003810
(43) Veröffentlichungstag der Anmeldung: 21.11.2012
(73) Patentinhaber: Henkel AG & Co. KGaA, 40589 Düsseldorf (DE)
(72) Erfinder: FREY, Daniel, 40597 Düsseldorf (DE); ZAUGG, Cedric, CH-2000 Neuchatel (CH); FERIANI, Amir, CH-2012 Auvernier (CH); SANDOZ, Jean-Paul, CH-2036 Cormondrèche (CH)
(86) Internationale Anmeldenummer: PCT/EP2010/067347
(87) Internationale Veröffentlichungsnummer: WO 2011/124277

(56) Entgegenhaltungen:
- EP-A1- 2 047 914
- EP-A2- 1 475 108
- DE-A1-102007 040 323

## Beschreibung

Die Erfindung betrifft eine elektrisch betriebene Abgabevorrichtung, insbesondere einen WC-Spüler, mit einer akustischen Signaldetektion, insbesondere einer Spülwasserdetektion, einer Freisetzung von Zubereitung, insbesondere in bzw. an einem Toilettenbecken, sowie einem akustischen Signalgeber, wobei die Signaldetektion, Freisetzung von Zubereitung sowie der akustische Signalgeber durch ein Piezoelement realisiert ist.

### Stand der Technik

Die genaue und bedarfsgerechte Dosierung von fließ- oder schüttfähigen Zusammensetzungen ist für eine Vielzahl von Anwendungsgebieten von Relevanz.

Insbesondere im Haushaltsbereich erfährt die Dosierung fließfähiger Substanzen eine steigende Bedeutung, was voranging in der exakten und bedarfsgesteuerten Dosierung der entsprechenden Wirkstoffe begründet ist, wodurch zum einen die Umwelt durch Ressourcenschonung und Vermeidung von Fehl- und Überdosierungen geschont, zum anderen die Effizienz der so dosierten Wirkstoffe optimiert wird.

Die Dosierung von Reinigungs- und Duftzusammensetzungen im WC-Bereich wird derzeit vorrangig durch sog. WC-Spüler realisiert. Hierbei handelt es sich um Ein- oder Mehrkammerbehältnisse, die derart in das WC-Becken gehangen werden, dass beim Spülvorgang des WC-Beckens mit Wasser eine Wirkstoffabgabe aus dem WC-Spüler in das Toilettenbecken erfolgt.

Derartige Vorrichtungen sind beispielsweise aus EP0828902 oder DE10113036 bekannt.

Ein wesentlicher Nachteil dieser WC-Spüler ist, dass die Dosierung im Wesentlichen von den jeweiligen lokalen Strömungsbedingungen im Toilettenbecken während des Spülvorgangs abhängt. Die Strömungsbedingungen können jedoch in Abhängigkeit vom Toilettentyp und der Positionierung des WC-Spülers in bzw. am Toilettenbecken sehr unterschiedlich sein. So kann es beispielsweise vorkommen, dass bei einigen Toilettentypen keine Wirkstofffreisetzung aus dem WC-Spüler erfolgt, da der WC-Spüler beim Spülvorgang nicht oder nicht hinreichend mit Wasser überströmt wird und der Dosiermechanismus des WC-Spülers somit nicht ausgelöst wird.

Auch falls ein WC-Spüler verwendungsgemäß von Spülwasser überströmt wird, so ist dies insoweit von Nachteil, als das es zu einer Störung der vom Toilettenhersteller vorgesehenen Wasserführung kommt, wodurch die Spülleistung einer Toilette spürbar reduziert werden kann.

Die Freisetzung der Wirkstoffe aus derartigen WC-Spülern erfolgt üblicher Weise durch die Penetration von Spülwasser durch Öffnungen im WC-Spüler, wobei die Zubereitungen angelöst und beim Austritt des Spülwassers durch entsprechende Austrittsöffnungen aus dem WC-Spüler ausgetragen und fortgeschwemmt werden. Je nach Anordnung des WC-Spülers in der Toilette wird dieser durch die häufig lokal sehr unterschiedlichen Strömungsverhältnisse des Spülwasseraustritts aus dem Beckenrand der Toilette unterschiedlich stark durchströmt, wodurch sich nur eine diffuse Abgabe der Wirkstoffe realisieren lässt.

Üblicherweise wird der Spülwasserstrom wie eingangs dargestellt durch das Einbringen eines WC-Spülers beeinflusst. Durch die geänderten Strömungsbedingungen kann es zu einem deutlich geänderten Abspülverhalten der Toilette kommen. Häufig wird der Spülwasserstrom in derart beeinflusst, dass Spritzwasser aus dem Toilettenbecken nach oben gespritzt wird, so dass Spülwasser aus dem Toilettenbecken austritt oder bei der Benutzung der Toilette in Berührung mit dem Benutzer kommen kann, was regelmäßig als unangenehm empfunden wird.

Des Weiteren wird durch eine gezielte Strömungsführung in den Toiletten versucht die verwendeten Spülwassermengen bei gleich bleibendem oder verbessertem Abspülverhalten weiter zu reduzieren, so dass ein Eingriff in die Spülwasserströmung bei derart optimierten Toiletten einen noch weitaus größeren Einfluss auf das Abspülverhalten hat.

Es wäre somit wünschenswert über eine Abgabevorrichtung zur Freisetzung von Wirkstoffen in ein Toilettenbecken zu verfügen, die eine vom Spülvorgang der Toilette unabhängige Dosierung von Wirkstoffen in das Toilettenbecken realisiert.

Neben der gezielten Dosierung von Zubereitungen im WC, hat eine genaue, bedarfsgerechte Dosierung von Zubereitungen insbesondere auch den Bereich der maschinellen Wasch- und Geschirrspülmittel erreicht. Diese maschinellen Wasch- und Geschirrspülmittel werden dem Verbraucher typischerweise in fester Form, beispielsweise als Pulver oder als Tabletten, zunehmend jedoch auch in flüssiger oder gelförmiger Form angeboten. Ein Hauptaugenmerk liegt dabei seit geraumer Zeit auf der bequemen Dosierung von Wasch- und Reinigungsmitteln und der Vereinfachung der zur Durchführung eines Wasch- oder Reinigungsverfahrens notwendigen Arbeitsschritte.

Ferner ist eines der Hauptziele der Hersteller maschineller Wasch- und Reinigungsmittel die Verbesserung der Wasch- und Reinigungsleistung dieser Mittel, wobei in jüngster Zeit ein verstärktes Augenmerk auf die Wasch- und Reinigungsleistung bei Niedrigtemperatur-Wasch- und Reinigungsgängen und/oder in Wasch- und Reinigungsgängen mit verringertem Wasserverbrauch gelegt wird. Hierzu wurden den Wasch- und Reinigungsmitteln vorzugsweise neue Inhaltsstoffe, beispielsweise wirksamere Tenside, Polymere, Enzyme und/oder Bleichmittel zugesetzt. Da neue Inhaltsstoffe jedoch nur in begrenztem Umfang zur Verfügung stehen und die pro Wasch- und Reinigungsgang eingesetzte Menge der Inhaltsstoffe aus ökologischen und wirtschaftlichen Gründen nicht in beliebigem Maße erhöht werden kann, sind diesem Lösungsansatz natürliche Grenzen gesetzt.

In diesem Zusammenhang sind in jüngster Zeit insbesondere Vorrichtungen zur Mehrfachdosierung von Wasch- und Reinigungsmitteln in das Blickfeld der Produktentwickler geraten. Bei diesen Vorrichtungen kann zwischen in die Geschirrspülmaschine oder Textilwaschmaschine integrierten Dosierkammern einerseits und eigenständigen, von der Geschirrspülmaschine oder Textilwaschmaschine unabhängigen Vorrichtungen andererseits unterschieden werden. Mittels dieser Vorrichtungen, welche die mehrfache der für die Durchführung eines Wasch- oder Reinigungsverfahrens notwendigen Wasch- oder Reinigungsmittelmenge enthalten, werden Waschoder Reinigungsmittelportionen in automatischer oder halbautomatischer Weise im Verlauf mehrerer aufeinander folgender Wasch- oder Reinigungsverfahren in den Innenraum des wasserführenden Haushaltsgeräts dosiert. Für den Verbraucher entfällt die Notwendigkeit der manuellen Dosierung bei jedem Reinigungs- bzw. Waschgang. Beispiele für derartige Vorrichtungen werden in der europäischen Patentanmeldung EP 1 759 624 A2 (Reckitt Benckiser) oder in der deutschen Patentanmeldung DE 10 2005 062 479 A1 (BSH Bosch und Siemens Hausgeräte GmbH) beschrieben.

DE 10 2007 040 323 A (Henkel) offenbart eine Abgabevorrichtung zur Abgabe einer Fließfähigen Zubereitung, umfassend ein piezoelektrisches Element wahlweise als Sensoreinheit oder Steuereinheit.

Zur Detektion eines Spül- bzw. Waschabschnitts innerhalb eines Behandlungsprogramms eines wasserführenden Haushaltsgeräts ist es wünschenswert eine möglichst einfache und sichere Sensorik und zur Dosierung der entsprechenden Zubereitungen ein möglichst einfaches Abgabeelement zur Verfügung zu haben.

Ferner ist es wünschenswert, dass ein Benutzer Signale von einer derartigen Abgabevorrichtung erhält, beispielsweise um das Versprühen einer Zubereitung oder das Ende eines Sprühvorgangs anzuzeigen.

Aufgabe der Erfindung ist es daher, ein eine kostengünstig herstellbare und kompakte Vorrichtung bereitzustellen, die Zubereitungen zu vorbestimmten, sensorisch erfassten Meßgrößen dosiert und welche dem Benutzer zumindest den Beginn und/oder das Ende der Wirkstoffabgabe anzeigt.

Die Aufgabe wird durch eine Abgabevorrichtung gemäß den Merkmalen des Anspruchs 1 gelöst.

Vorteilhafte Ausgestaltungen der erfindung sind mit den Unteransprüchen angegeben.

Obwohl die erfindungsgemäße Abgabevorrichtung nachfolgend für das Anwendungsbeispiel eines WC-Spülers näher erläutert wird, so ist die Erfindung jedoch nicht hierauf beschränkt. Vielmehr sind die Verwendung der erfindungsgemäßen Abgabevorrichtung in Geschirrspülmaschinen, Waschmaschinen, Wäschetrocknern denkbar und werden an nachfolgender Stelle noch näher erläutert.

Die erfindungsgemäße Abgabevorrichtung zur Abgabe einer fließfähigen Zubereitung, insbesondere ein WC-Spüler zur Befestigung am Rand einer Toilette, umfasst eine elektrische Energiequelle, eine Steuereinheit, die mit der Energiequelle, einer Sensoreinheit, einem Abgabeelement und einem Schallwandler verbunden ist, wobei die Sensoreinheit, ein piezoelektrisches Element ist, das geeignet ist Schwingungen, insbesondere Schallwellen und/oder beispielsweise elektromagnetische Wellen in einem Frequenzbereich von 1 kHz - 300 kHz, bevorzugt 20 - 25 kHz und/oder Körperschall aus der Umgebung der Abgabevorrichtung aufzunehmen und in ein Sensorsignal zu wandeln, welches in der Steuereinheit in ein Steuersignal, insbesondere für das Abgabeelement, gewandelt wird; das Abgabeelement ein piezoelektrisches Element ist, dass von der Steuereinheit mit elektrischen Signalen beaufschlagt wird und wenigstens eine erste Zubereitung aus wenigstens einem ersten Behälter, der kommunizierend mit dem Abgabeelement verbunden ist, versprüht; der Schallwandler ein piezoelektrisches Element ist, dass von der Steuereinheit mit elektrischen Signalen beaufschlagt wird und die das piezoelektrische Element in hörbare akustische Signale in einem Frequenzbereich von 20 Hz bis 20 kHz, bevorzugt 5 - 15 kHz, insbesondere bevorzugt 7 - 10 kHz wandelt, wobei die Sensoreinheit, das Abgabeelement und der Schallwandler als ein Bauteil ausgebildet sind.

Bei einer alternativen bevorzugten Variante unterscheidet sich die erfindungsgemäße Abgabevorrichtung von der beschrieben lediglich dadurch, dass die Sensoreinheit ein piezoelektrisches Element ist, welches geeignet ist Schwingungen, insbesondere Schallwellen und/oder beispielsweise elektromagnetische Wellen in einem Frequenzbereich von 1 kHz - 300 kHz, bevorzugt.20 - 41 kHz, insbesondere bevorzugt 27 - 41 kHz aus der Umgebung der Abgabevorrichtung aufzunehmen und in ein Sensorsignal zu wandeln.

Das piezoelektrische Element der beschriebenen Abgabevorrichtungen nimmt also in den Abgabevorrichtungen drei Funktionen war. Zum einen dient es als Sensor zur Erfassung von Schwingungen, Schall und Körperschall, zum anderen als Abgabeelement zum Versprühen von Zubereitung und als akustischer Signalgeber. Hierdurch ist es möglich, die Abgabevorrichtung kompakt auszuführen und kostengünstig herzustellen.

Besonders zu bevorzugen ist es, dass der piezo-elektrische Sensor konfiguriert ist, Schallwellen in einem Bereich von 20 - 25 kHz zu detektieren und die Steuereinheit insbesondere diesen Frequenzbereich auswertet, da in diesem Frequenzband vergleichsweise geringe Störgeräusche durch Schall oder elektromagnetische Wellen von z.B. Lampen auftreten.

In der oberhalb beschriebenen alternativen Variante kann der piezo-elektrische Sensor alternativ derart konfiguriert sein, Schwingungen, insbesondere Schallwellen und/oder beispielsweise elektromagnetische Wellen in einem Bereich von 20 - 41 kHz, besonders bevorzugt 27 - 41 kHz aus der zu detektieren. In diesem Fall würde eine detektierbare Frequenz beispielsweise oberhalb des hörbaren Frequenzbereiches liegen und unter dem Frequenzbereich von beispielsweise Leuchtstoffröhren liegen.

Das hörbare akustische Signal kann bei den beschriebenen Abgabevorrichtungen ein einfacher, monophoner Piepton bei konstanter Frequenz sein, oder aber monophone Tonfolgen unterschiedlicher Frequenz sowie auch komplexere Signale wie beispielsweise polyphone Tonfolgen oder Sprache sowie die Widergabe digitalisierter Musik oder Geräusche.

Es ist bevorzugt, dass die elektrischen Signale, die das Versprühen einer Zubereitung bewirken, eine Frequenz von 70 - 400 kHz, bevorzugt 80 - 90 kHz aufweisen und die elektrischen Signale, die die Erzeugung eines hörbaren akustischen Signals bewirken eine Frequenz von 20 Hz - 20 kHz bevorzugt von 5 - 15 kHz und insbesondere bevorzugt von 7 - 10 kHz aufweisen.

Es ist denkbar, das piezoelektrische Element mit den elektrischen Signalen, die das Versprühen einer Zubereitung bewirken und den elektrischen Signalen, die die Erzeugung eines hörbaren akustischen Signals bewirken, durch die Steuereinheit zeitgleich und/oder zeitversetzt zu beaufschlagen. Bei einer zeitgleichen Beaufschlagung kann dem Benutzer beispielsweise akustisch angezeigt werden, dass das Abgabeelement aktiv ist und Zubereitung versprüht wird. Bei einer zeitversetzten Beaufschlagung kann ein entsprechendes akustisches Signal beispielsweise den Beginn und/oder das Ende eines Abgabeprozesses anzeigen. Selbstverständlich sind in diesem Zusammenhang beliebige Kombinationen denkbar. Beispielsweise wäre es auch möglich den Beginn eines Abgabeprozesses mit einem ersten akustischen Signal, die Wirkstoffabgabe mit einem zweiten akustischen Signal und das Ende des Abgabeprozesses mit einem dritten akustischen Signal anzuzeigen, wobei vorteilhafter Weise die akustischen Signale voneinander verschieden sind.

Zur Verwendung der Abgabevorrichtung als WC-Spüler ist es vorteilhaft, dass die Sensoreinheit derart konfiguriert ist, dass sie Körperschall eines Toilettenbeckens, der durch das Auslösen des Spülwasserstroms erzeugt wird, erfasst und ein Sensorsignal erzeugt wird, dass das Auslösen des Spülwasserstroms repräsentiert. Ferner ist es zu bevorzugen, dass die Sensoreinheit derart konfiguriert ist, dass sie Schall innerhalb des Toilettenbeckens, der durch das Auslösen des Spülwasserstroms bewirkt wird, erfasst und ein Sensorsignal erzeugt wird, dass das Auslösen des Spülwasserstroms repräsentiert.

Um eine möglichst gute Erkennung eines Spülwasserstroms zu gewährleisten, ist es von Vorteil, dass die Sensoreinheit und das Abgabeelement in das Innere des Toilettenbeckens gerichtet sind.

Die Erfindung schließt ferner ein Verfahren zum Betrieb der erfindungsgemäßen Abgabevorrichtung ein, wobei das Verfahren die folgenden Schritte, dass
□ eine Sensoreinheit, die ein piezoelektrisches Element ist, Schwingungen, insbesondere Schallwellen in einem Frequenzbereich von 1 kHz - 300 kHz, bevorzugt 20 - 25 kHz und/oder Körperschall aus der Umgebung der Abgabevorrichtung aufnimmt und in ein Sensorsignal wandelt,
□ ein Abgabeelement, dass ein piezoelektrisches Element ist, von der Steuereinheit beim Vorliegen eines definierten Sensorsignals mit elektrischen Signalen beaufschlagt wird, so dass wenigstens eine erste Zubereitung (10) aus wenigstens einem ersten Behälter (9), der kommunizierend mit dem Abgabeelement verbunden ist, versprüht und/oder vernebelt wird,
□ ein Schallwandler, der ein piezoelektrisches Element ist, von der Steuereinheit (4) vor und/oder während und/oder nach dem Versprühen der Zubereitung mit elektrischen Signalen beaufschlagt wird, die das piezoelektrische Element in hörbare akustische Signale in einem Frequenzbereich von 20 Hz bis 20 kHz, bevorzugt 5 - 15 kHz, insbesondere bevorzugt 7 - 10 kHz wandelt,
umfasst.

Ein alternatives bevorzugtes Verfahren unterscheidet sich von dem beschriebenen Verfahren lediglich dadurch, dass eine Sensoreinheit, die ein piezoelektrisches Element ist, Schwingungen, insbesondere Schallwellen und/oder beispielsweise elektromagnetische Wellen in einem Frequenzbereich von 1 kHz - 300 kHz, bevorzugt 20 - 41 kHz, insbesondere bevorzugt 27 - 41 kHz aus der Umgebung der Abgabevorrichtung aufnimmt und in ein Sensorsignal wandelt,

Die erfindungsgemäße Angabevorrichtung beider beschriebenen Verfahren besteht aus verschiedenen Bauelementen die ihrerseits wiederum zu Baugruppen zusammengefasst sein können. Die Bauelemente der Abgabevorrichtung können ein Abgabeelement, eine Steuereinheit, eine Sensoreinheit, einen akustischen Schallwandler, eine Energiequelle, einen Behälter, ein Befestigungsmittel und eine Zubereitung umfassen. Die Bauelemente Steuereinheit, Sensoreinheit, Abgabeelement, akustischer Schallwandler und Energiequelle können in einer bevorzugten Ausführungsform der Erfindung zu der Baugruppe "Dosiergerät" zusammengefasst sein. Die Bauelemente und Baugruppen werden nachfolgend beschrieben.

### Dosiergerät

In dem Dosiergerät ist die zum Betrieb der Abgabevorrichtung notwendige Energiequelle, eine Steuereinheit, eine Sensoreinheit, ein Abgabeelement sowie ein akustischer Schallwandler integriert. Vorzugsweise besteht das Dosiergerät aus einem spritzwassergeschütztem Gehäuse, dass das Eindringen von Spritzwasser, wie es beispielsweise bei der Verwendung der erfindungsgemäßen Abgabevorrichtung als WC-Spülers in einem Toilettenbecken auftreten kann, in das Innere des Dosiergeräts verhindert.

Ferner ist es bevorzugt, dass das Dosiergerät am äußeren Rand des Toilettenbeckens angeordnet ist, wodurch zum einen ein Schutz vor Spritzwassereinfluss und zum anderen eine konveniente Bedienung des Dosiergeräts ermöglicht ist. Ferner ragt das Dosiergerät nicht ins Innere der Toilette wodurch durch die außenrandseitige Anordnung die nutzbare Querschnittsfläche des Toilettenbeckens nicht verringert wird.

Ein wesentlicher Vorteil der Erfindung ist in der Trennung der Abgabevorrichtung in ein Dosiergerät und in ein mit dem Dosiergerät koppelbaren Behälter zu sehen, wodurch die Abgabevorrichtung flexibel für die unterschiedlichsten Anwendungsfälle verwendet und auf einfache Weise angepasst werden kann.

### Abgabeelement

Als Abgabeelemente werden jegliche Art von Vorrichtungen bezeichnet, die geeignet sind, eine Zubereitung an die Umgebung der Abgabevorrichtung abzugeben. Insbesondere ist ein Abgabeelement als piezoelektrisches Element zum Versprühen und/oder Vernebeln von Zubereitung ausgebildet.

Besonders bevorzugt ist es, dass das Abgabeelement geeignet ist, wenigstens eine erste Zubereitung aus wenigstens einem ersten Behälter, der kommunizierend mit dem Abgabeelement verbunden ist, auf eine Oberfläche, insbesondere auf eine Oberfläche in einem Toilettenbecken, zu applizieren, wobei das Abgabeelement ein piezoelektrisches Element ist.

Vorteilhaft ist es, das Abgabeelement und die Steuereinheit in derart zu konfigurieren, dass mittels einer Amplitudenmodulation der das Abgabeelement anregenden Schwingung, die Freisetzungsgeschwindigkeit von Wirkstofffluid aus dem Abgabeelement einstellbar ist, wodurch ein durch die untere und obere Geschwindigkeitsgrenzen definiertes Applikationsfeld innerhalb des Toilettenbeckens mit Wirkstofffluid benetzt wird. Hierdurch wird es möglich, nicht nur einen definierten, punktartigen "Applikationsfleck" in das Toilettenbecken einzubringen, sondern ein flächenartiges Applikationsfeld.

In einer vorteilhaften Weiterentwicklung der Erfindung sind das Abgabeelement und die Steuereinheit in derart konfiguriert, dass das Abgabeelement ein akustisches Signal im hörbaren Bereich erzeugt.

Die Abgabeelemente können gleiche oder verschiedene Sprühkegelformen bei der Abgabe der Zubereitungen aufweisen. So ist es beispielsweise denkbar, dass ein Abgabeelement einen Strahl mit einer eher punktförmigen Applikationsfläche, während ein anderes Abgabeelement ein flächiges Applikationsfeld erzeugt. Selbstverständlich sind diverse Kombinationen verschiedenster Sprühkegelformen denkbar.

Das Abgabeelement kann des Weiteren Mittel zur elektrostatischen Aufladung von Wirkstofftröpfchen vorsehen, wodurch die Benetzung, Anhaftung und/oder Verteilung des Wirkstoffs auf einer Oberfläche und/oder in der Luft verbessert wird.

Es ist des Weiteren von Vorteil, das Abgabeelement beweglich am Bügel des WC-Spülers anzuordnen. Hierdurch kann das Abgabeelement und der Sprühkegel der Zubereitung vom Benutzer gezielt ausgerichtet werden um ein definiertes Applikationsfeld in oder an der Toilette mit Zubereitung zu benetzen.

Das bzw. die Abgabeelemente sind in vorteilhafter Weise derart konfiguriert, dass eine definierte Abgabemenge wenigstens einer Wirkstoffzubereitung unabhängig von der Positionierung des WC-Spülers am Toilettenbecken gerichtet und definiert in das Innere eines Toilettenbeckens appliziert wird. Vorteile einer derartigen Ausgestaltung sind u.a. die spezifischere Exposition von Toilettenbeckenoberflächen mit einem oder mehreren Wirkstoffen, wobei unterschiedliche Oberflächen mit voneinander verschiedenen Wirkstoffen behandelt werden können. Beispielsweise kann bei einem Flachspüler die Pfanne mit einem Wirkstoff zur Verminderungen von Anhaftungen benetzt werden, während auf die trichterförmig von der Pfanne zum Rand der Toilette hin verlaufenden Wände ein Wirkstoff zu Verminderung von Kalkablagerungen appliziert wird.

### Steuereinheit

Insbesondere kann es sich bei der Steuereinheit um einen programmierbaren Mikroprozessor handeln. In einer besonders bevorzugten Ausführungsform der Erfindung ist auf dem Mikroprozessor eine Mehrzahl von Dosierprogrammen gespeichert, die entsprechend dem an dem WC-Spüler gekoppelten Behälter auswählbar und ausführbar sind. Selbstverständlich ist es ebenfalls denkbar, dass die Dosierprogramme manuell vom Benutzer abrufbar sind.

Die Steuereinheit ist bevorzugt auch der nach Außen gerichteten Seite des Toilettenbeckens angeordnet, von wo aus sie durch den Benutzer auf einfache weise bedient werden kann, insbesondere wenn der Benutzer auf der Toilette sitzt.

Die Steuereinheit kann in einer besonders bevorzugten Ausgestaltung der Erfindung ein Dosierprogramm zum Einbringen von wenigstens zwei voneinander unterschiedlichen Wirkstoffzubereitungen in ein Toilettenbecken oder in die Umgebung des Toilettenbeckens umfassen, bei dem an zumindest zwei aufeinander folgenden Zeitpunkten t₁ und t₂ wenigstens zwei voneinander unterschiedliche Wirkstoffzubereitungen freigesetzt werden, wobei wenigstens eine Wirkstoffzubereitung in den Innenraum eines Toilettenbeckens eingebracht wird.

Ein wesentlicher Vorteil eines derartigen Dosierprogramms ist u.a. eine optimierte Reinigungsleistung durch genauste Steuerung möglicher chemischer Reaktionen durch eine entsprechend zeitversetzte Freigabe der entsprechenden Zubereitung oder Zubereitungen, von denen einige, jedoch nicht abschließende Beispiele in der nachfolgenden Tabelle aufgeführt sind.

| t₁ | t₂ | Vorteil |
|---|---|---|
| Reiniger in Toilettenbecken beim Spülvorgang | Duftstoff in Toilettenbecken nach dem Spülgang | Optimierte Duftstoffentfaltung, da Duftstoff nach dem Spülgang in das Toilettenbecken freigesetzt wird und so nicht mit dem Spülwasser weggespült wird. Duftstoff wird nicht durch Reinigerzubereitung "zersetzt". |
| Duftstoff in Toilettenbecken unmittelbar vor Benutzung | Reiniger in Toilettenbecken beim Spülvorgang | Optimierte Duftstoffentfaltung, da Duftstoff vor dem Spülgang in das Toilettenbecken freigesetzt wird und so nicht mit dem Spülwasser weggespült wird. Duftstoff wird nicht durch Reinigerzubereitung "zersetzt". |
| Reiniger A in Toilettenbecken unmittelbar vor Benutzung | Reiniger B in Toilettenbecken beim Spülvorgang | Reiniger A kann Anhaftungen im Toilettenbecken verhindern, indem ein Schutzfilm aus Reiniger A unmittelbar vor Benutzung der Toilette im Toilettenbecken aufgebracht wird, der dann während des Abspülvorgangs von Reiniger B wieder von der Toilettenoberfläche gespült wird. |

### Sensoreinheit

Die Sensoreinheit kann einen oder mehrere aktive und/oder passive Sensoren zur qualitativen und/oder quantitativen Erfassung mechanischer, elektrischer, physikalischer und/oder chemischer Größen umfassen, die als Steuersignale an die Steuereinheit geleitet werden.

Insbesondere können die Sensoren der Sensoreinheit aus der Gruppe der Zeitgeber, Infrarotsensoren, Helligkeitssensoren, Temperatursensoren, Bewegungssensoren, Dehnungssensoren, Drehzahlsensoren, Näherungssensoren, Durchflusssensoren, Farbsensoren, Gassensoren, Vibrationssensoren, Drucksensoren, Leitfähigkeitssensoren, Trübungssensoren, Schallwechseldrucksensoren, "Lab-on-a-Chip"-Sensoren, Kraftsensoren, Beschleunigungssensoren, Neigungssensoren, pH-Wert-Sensoren, Feuchtigkeitssensoren, Magnetfeldsensoren, RFID-Sensoren, Magnetfeldsensoren, Hall-Sensoren, Bio-Chips, Geruchssensoren, Schwefelwasserstoffsensoren und/oder MEMS-Sensoren ausgewählt sein.

Die Sensoreinheit und das Abgabeelement sind insbesondere als ein Bauteil ausgebildet.

Es ist besonders bevorzugt, dass die Sensoreinheit ein piezoelektrisches Element ist, das geeignet ist, Schwingungen von der Umgebung und/oder aus der Umgebung der Toilette aufzunehmen und in ein Sensorsignal zu wandeln, welches in der Steuereinheit in ein Steuersignal, insbesondere für das Abgabeelement, gewandelt wird.

Die piezoelektrische Sensoreinheit kann in Verbindung mit der entsprechenden Steuereinheit auch so konfiguriert sein, dass z.B. Einspülgeräusche einer Waschmaschine, Rotationsvibrationen einer Waschtrommel, Laufgeräusche und/oder Vibrationen einer Pumpe einer Wasch- oder Spülmaschine oder eines Wäschetrockners, Sprühgeräusche im Inneren eines Geschirrspülers oder dergleichen erfasst und hinsichtlich des Dosierzeitpunkts und/oder Dosiermenge einer Zubereitung ausgewertet werden.

In einer vorteilhaften Ausgestaltung der Erfindung ist die Sensoreinheit derart konfiguriert, dass ein Auslösen des Spülwasserstroms ohne Eingriff in die Spülwasserströmung erfasst und ein Sensorsignal erzeugt wird, dass das Auslösen des Spülwasserstroms repräsentiert.

Gemäß einer bevorzugten Ausführung der Erfindung ist die Sensoreinheit derart konfiguriert, dass sie Körperschall des Toilettenbeckens, der durch das Auslösen des Spülwasserstroms bewirkt wird, erfasst und ein Sensorsignal erzeugt wird, dass das Auslösen des Spülwasserstroms repräsentiert.

Alternativ hierzu oder zusätzlich kann die Sensoreinheit auch derart konfiguriert sein , dass sie Schall innerhalb des Toilettenbeckens, der durch das Auslösen des Spülwasserstroms bewirkt wird, erfasst und ein Sensorsignal erzeugt wird, dass das Auslösen des Spülwasserstroms repräsentiert.

Es ist vorteilhaft, dass die Sensoreinheit und das Abgabeelement in das Innere des Toilettenbeckens gerichtet sind.

Des weiteren ist es zu bevorzugen, dass die Sensoreinheit und die Steuereinheit in derart konfiguriert sind, dass ein Sensorsignal in derart erzeugt und/oder ausgewertet wird, dass die Benetzung des Abgabeelements mit Wirkstofffluid repräsentiert und/oder detektierbar ist. Hierdurch wird es beispielsweise möglich, nach vollständiger Entleerung der Wirkstoffbehälter ein entsprechendes Signal zu erzeugen, welches die Entleerung dem Verbraucher anzeigt.

Die Sensoreinheit kann in ihrer einfachsten denkbaren Ausführungsform auch als ein Kipp-, Druckoder Tastschalter ausgeführt sein.

### Energiequelle

Im Sinne dieser Anmeldung wird als Energiequelle ein Bauelement der Abgabevorrichtung verstanden, welches zweckmäßig ist, eine zum autarken Betrieb der Abgabevorrichtung geeignete Energie bereit zu stellen.

Vorzugsweise stellt die Energiequelle elektrische Energie zur Verfügung. Bei der Energiequelle kann es sich beispielsweise um eine Batterie, ein Netzgerät, Solarzellen oder dergleichen handeln.

Besonders vorteilhaft ist es, die Energiequelle austauschbar auszuführen, zum Beispiel in Form einer auswechselbaren Batterie.

Es ist jedoch prinzipiell auch denkbar, dass es sich bei der Energiequelle um eine mechanische Energiequelle handelt, wie beispielsweise einen Dynamo, der eine mechanische oder fluidische Energie in elektrische Energie umwandelt. Diese kann dann in geeigneten Speicherelementen wie zum Beispiel einem Kondensator oder Akkumulator gespeichert werden.

### Behälter

Unter einem Behälter im Sinne dieser Anmeldung wird ein Packmittel verstanden, das dazu geeignet ist, Zubereitungen zu umhüllen oder zusammenzuhalten und das zur Abgabe der Zubereitung an das Dosiergerät koppelbar ist.

Besonders bevorzugt ist eine Anordnung, bei der zwei Behälter vorgesehen sind, die, weiter bevorzugt, voneinander separiert sind und jeweils ein Wirkstofffluid enthalten. Es kann aber auch mehrere Vorratsbehälter für mehrere Wirkstofffluide geben. Die Vorratsbehälter sind voneinander separiert, um eine vorzeitige Mischung der Wirkstofffluide zu unterbinden. Sie können körperlich separat oder als separate Abteile in einem zusammenhängenden Körper ausgebildet sein.

Der Behälter weist üblicherweise ein Füllvolumen von <5.000 ml, insbesondere <1.000 ml, bevorzugt <500ml, besonders bevorzugt <250 ml, ganz besonders bevorzugt < 50 ml auf.

Die Erfindung ist insbesondere geeignet für formstabile Behältnisse wie Becher, Dosen, Kartuschen, Patronen, Flaschen, Kanister, Kannen, Schachteln, Trommeln oder Tuben, kann jedoch auch für flexible Behältnisse wie Beutel oder Säcke verwendet werden, insbesondere, wenn sie gemäß des bag-in-bottle-Prinzips verwendet werden.

Insbesondere kann ein Behälter auch mehrere Kammern umfassen, die mit voneinander verschiedenen Zusammensetzungen befüllbar sind. Auch ist es denkbar, dass eine Behältermehrzahl zu einer Einheit, beispielsweise zu einer Patrone, angeordnet wird.

Beispiele für mögliche Kombinationen von Behältern bzw. Kammern mit den entsprechenden Zubereitungen sind für einige Anwendungsfälle in folgender Tabelle beispielhaft zusammengestellt.

| Behälter A | Behälter B | Behälter C |
|---|---|---|
| Reinigungsmittel | Duftstoff | |
| Reinigungsmittel A | Reinigungsmittel B | |
| Reinigungsmittel A | Reinigungsmittel B | Duftstoff |

In einer bevorzugten Ausführungsform der Erfindung, weist der Behälter ein RFID-Etikett auf, dass zumindest Informationen über den Inhalt des Behälters beinhaltet und das durch die Sensoreinheit auslesbar ist.

Diese Informationen können verwendet werden, um ein in der Steuereinheit gespeichertes Dosierprogramm auszuwählen. Hierdurch kann sichergestellt werden, dass stets ein für eine bestimmte Zubereitung optimales Dosierprogramm verwendet wird. Es kann auch vorgesehen sein, dass bei nicht Vorhandensein eines RFID-Labels oder bei einem RFID-Label mit einer falschen oder fehlerhaften Kennung, keine Dosierung durch die Abgabevorrichtung erfolgt und statt dessen ein optisches oder akustisches Signal erzeugt wird, dass den Benutzer auf den vorliegenden Fehler hinweist.

Um einen Fehlgebrauch der Behälter auszuschließen, können die Behälter auch strukturelle Elemente aufweisen, die mit korrespondierenden Elementen des Dosiergeräts nach dem Schlüssel-Schloss-Prinzip zusammenwirken, so dass beispielsweise nur Behälter eines bestimmten Typs an das Dosiergerät koppelbar sind. Ferner ist es durch diese Ausgestaltung möglich, dass Informationen über den an das Dosiergerät gekoppelten Behälter an die Steuereinheit übertragen werden, wodurch eine auf den Inhalt des dementsprechenden Behälters abgestimmte Steuerung der Abgabevorrichtung erfolgen kann.

In einer weiteren Ausgestaltung der Erfindung, kann der Behälter unter Druck stehen. Dies ist insbesondere von Vorteil, wenn die Zubereitung versprüht oder abgegeben werden soll, ohne dass eine Zwischenschaltung einer Pumpe notwendig ist. In diesem Fall kann die Abgabe der Zubereitung beispielsweise durch ein Stellventil gesteuert bzw. reguliert werden, dass in Wirkverbindung mit der Steuereinheit steht. Diese Ausführung hat den weiteren Vorteil, dass keine Energie für den Transport der Zubereitung von der Energiequelle bereit gestellt werden muss, womit die Energiequelle entweder kleiner dimensioniert werden kann oder eine längere Lebenserwartung aufweisen wird.

### Befestigungsmittel

Der WC-Spüler umfasst des Weiteren Befestigungsmittel, um den WC-Spüler am Toilettenbecken zu fixieren. Die Befestigungsmittel können beispielsweise als Saugnapf, Klebeband, Bügel oder dergleichen ausgebildet sein.

Die Befestigung des WC-Spülers kann alternativ auch am Spülkasten der Toilette, der Toilettenbrille oder am Toilettendeckel erfolgen. Hierzu können die im Stand der Technik hinlänglich bekannten Befestigungsmittel verwendet werden.

### Zubereitungen

Zubereitungen im Sinne dieser Anmeldungen sind Zusammensetzungen, die wenigstens eine Substanz aus der Gruppe der Reinigungsmittel und/oder Duftstoffe enthalten.

Gemäß einer weiteren, bevorzugten Ausgestaltung der Erfindung, umfassen die Zubereitungen Substanzen zur Modifikation von Oberflächen, insbesondere von keramischen Oberflächen.

Erfindungsgemäß geeignete Zubereitungen sind beispielsweise Duftphasen, insbesondere parfümierte Duftphasen. Solche Duftphasen enthalten üblicherweise mindestens einen Duftstoff, vorzugsweise Parfümöl, mindestens ein Tensid oder einen Emulgator und Wasser sowie ggf. weitere Inhaltsstoffe wie Konservierungsmittel, Verdickungsmittel, Komplexbildner, Farbstoffe, weitere Tenside oder Emulgatoren, Stabilisatoren, Kalklöser etc.

Erfindungsgemäß ebenso geeignet als Zubereitungen sind Bleichphasen, insbesondere chlorhaltige Bleichphasen, vorzugsweise Bleichphasen auf Basis von Hypochlorit, wobei die Bleichphasen üblicherweise neben dem eigentlichen Bleichmittel und Wasser ggf. weitere Inhaltsstoffe wie Verdickungsmittel, Tenside oder Emulgatoren, Neutralisierungsmittel, Farbstoffe, Duftstoffe etc. enthalten können.

Weitere erfindungsgemäß geeignete Zubereitungen sind kalklösende Wirkstoffphasen, vorzugsweise saure kalklösende Wirkstoffphasen. Solche kalklösende Wirkstoffphasen können neben dem eigentlichen Kalklöser - vorzugsweise handelt es sich hierbei um eine organische oder anorganische Säure - und Wasser ggf. weitere Inhaltsstoffe wie Tenside oder Emulgatoren, Verdickungsmittel, Duftstoffe, Konservierungsmittel etc. enthalten.

Gleichermaßen ist es möglich, als Zubereitungen hochkonzentrierte Tensidphasen, sogenannte "Schaumbooster", einzusetzen. Solche hochkonzentrierten Tensidphasen können neben den Tensiden auch noch weitere, übliche Inhaltsstoffe enthalten. Derartige Schaumbooster sind insbesondere von Vorteil zur Vorbehandlung des Toilettenbeckens mit einem Schaumteppich, um beispielsweise ein Anhaften von Stoffwechselausscheidungsprodukten auf der Toilettenoberfläche zu verhindern bzw. zu reduzieren und/oder eine Kapselung von Schlechtgerüchen zu bewirken.

Erfindungsgemäß ebenfalls geeignet sind Zubereitungen mit antibakterieller und/oder fungizider und/oder antiviraler Aktivstoffphase, wobei die Aktivstoffphase neben dem antibakteriell und/oder fungizid und/oder antiviral wirkenden Aktivstoff und Wasser ggf. weitere Inhaltsstoffe, wie zum Beispiel Tenside oder Emulgatoren, Verdickungsmittel, Duftstoffe, Konservierungsmittel etc., enthalten kann.

Weiter ist es möglich, dass es sich bei den Zubereitungen um enzymhaltige Aktivstoffphasen handelt. Solche enzymhaltigen Aktivstoffphasen können neben Enzym(en) und Wasser ggf. weitere Inhaltsstoffe wie Tenside oder Emulgatoren, Verdickungsmittel, Duftstoffe, Konservierungsmitteln etc., enthalten.

Gleichermaßen ist es möglich, dass es sich bei den erfindungsgemäß eingesetzten Zubereitungen um absorbierende, insbesondere geruchsabsorbierende Wirkstoffphasen handelt. Diese können neben dem Absorptionsmittel, insbesondere Geruchsabsorptionsmittel, und Wasser ggf. weitere Inhaltsstoffe wie Tenside oder Emulgatoren, Verdickungsmittel, Duftstoffe, Konservierungsmittel etc. enthalten.

Der erfindungsgemäße WC-Spüler bietet gemäß einer besonderen Ausführungsform die Möglichkeit, in den Vorratsbehältern Kombinationen unterschiedlicher Zubereitungen einzusetzen, wobei gemäß einer bevorzugten Ausführungsform einer der Vorratsbehälter eine Duftphase, insbesondere wie zuvor definiert, enthält.

Beispiele für einzusetzende Zubereitungskombinationen sind parfümierte Duftphase kombiniert mit Chlorbleiche (miteinander zusammen nicht lagerstabil), parfümierte Duftphase mit hochkonzentrierter Tensidphase (Schaumbooster), Duftphase mit kalklösender, saurer Wirkstoffphase, Duftphase mit antibakterieller Wirkstoffphase, unterschiedliche Säure-Systeme, Duftphase kombiniert mit enzymhaltiger Wirkstoffphase, parfümierte Säurephase kombiniert mit wasserfärbender Phase, Duftphase mit geruchsabsorbierender Phase, parfümierte Säurephase mit Aktivsauerstoff, parfümierte Säurephase mit Wirkstoffphase, mit Polyacrylat verdickt etc.

Von besonderem Interesse sind dabeizähflüssige bis gelartige Wirkstofffluide mit Viskositäten im Bereich einiger tausend mPas, insbesondere von 200 bis 5000 mPas, vorzugsweise 500 bis 3500 mPas (gemessen mit RotoVisko LVTV II, Spindel 31, 5 U/min, 20 °C).

In einer weiteren, bevorzugten Ausgestaltung der Erfindung weisen die Zubereitungen eine Viskosität kleiner als 2000 mPas, insbesondere kleiner 1000 mPas, (gemessen mit RotoVisko LVTV II, Spindel 31, 5 U/min, 20 °C) auf. Derartig dünnflüssige bis wässrige Zubereitungen eignen sich insbesondere wenn die Zubereitung im oder am Toilettenbecken versprüht werden soll.

Durch die Verwendung von niedrigviskosen Wirkstoffzubereitungen kann in Verbindung mit dem erfindungsgemäßen WC-Spüler eine wesentlich schnellere und genauere Dosierung bewirkt und auf die Verwendung von Verdickungssystemen verzichtet werden. Ferner können Wirkstoffsysteme zum Einsatz kommen, die nur mit niedrigen Viskositäten darstellbar sind z.B. auf der Basis von Chlor, HCl, ect.

Die Erfindung wird nachfolgend anhand der lediglich Ausführungsbeispiele zeigenden Abbildungen näher erläutert. Es zeigen:

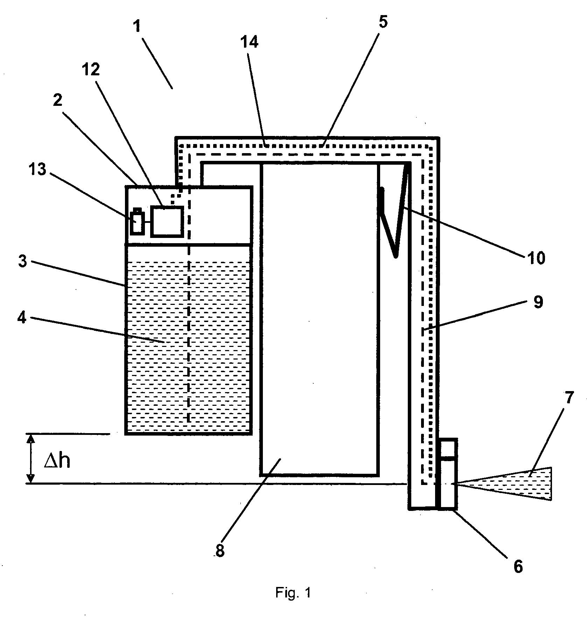

Fig. 1 WC-Spüler mit piezoelektrischem Element

In Fig.1 ist eine als WC-Spüler 1 ausgebildete Abgabevorrichtung gezeigt. Der WC-Spüler 1 besteht aus dem Dosiergerät 2 und einen mit dem Dosiergerät 2 koppelbaren Behälter 3, der eine Zubereitung 4 bevorratet. In Fig. 1 sind das Dosiergerät 2 und der Behälter 3 im gekoppelten Zustand abgebildet.

Vom Kopf des Dosiergeräts 2 verläuft ein U-förmig ausgebildeter Bügel 5, wobei in der gezeigten Betriebsposition am Toilettenbecken 8, das Dosiergerät 2 an dem an der Toilettenaußenseite verlaufenden vertikalen Schenkel des Bügels 5 angeordnet ist, während ein piezoelektrisches Element 6, dass als Abgabeelement, Sensoreinheit und akustischer Schallwandler am distalen Ende des an der Toiletteninnenseite verlaufenden vertikalen Schenkels des Bügels 5 positioniert ist, wobei der horizontale Schenkel des U-förmigen Bügels 5 auf dem Toilettenbecken 8 aufliegt.

Der Boden des Behälters 3 und die Abgabeöffnung des Abgabeelements 6 ist in Schwerkraftrichtung durch Höhenunterschied von Δh voneinander beabstandet. Das Abgabeelement 6 und der Behälter sind über die Leitung 9 kommunizierend miteinander verbunden, wobei die Leitung 9 bis zum Boden des Behälters 3 reicht. Durch den Höhenunterschied Δh wird Zubereitung 4 aus dem Behälter 3 durch die Leitung 9 zum Abgabeelement 6 gefördert.

Das Abgabeelement ist als piezoelektrisches Element 6 ausgebildet und wird von der Steuereinheit 12 mit elektrischen Signalen beaufschlagt, so dass die Zubereitung 4 aus dem Behälter 3, der kommunizierend mit dem Abgabeelement verbunden ist, versprüht und/oder vernebelt wird.

Die Sensoreinheit ist ebenfalls durch das piezoelektrischen Elemente 6 ausgeführt, wobei das piezoelektrische Element 6 der Art ausgeführt ist, dass es geeignet ist Schwingungen, insbesondere Schallwellen und/oder beispielsweise elektromagnetische Wellen in einem Frequenzbereich von 1 kHz - 300 kHz , bevorzugt 20 - 25 kHz und/oder Körperschall aus der Umgebung der Abgabevorrichtung aufzunehmen und in ein Sensorsignal zu wandeln, welches in der Steuereinheit 12 zur Steuerung der Abgabe von Zubereitung verwendet wird.

Alternativ kann es von Vorteil sein, das piezoelektrische Element 6 derart auszugestalten, dass es geeignet ist Schwingungen, insbesondere Schwallwellen und/oder beispielsweise elektromagnetische Wellen in einem Frequenzbereich von 1 kHz - 300 kHz, bevorzugt 20 - 41 kHz, insbesondere bevorzugt 27 - 41 kHz aus der Umgebung der Abgabevorrichtung aufzunehmen und in ein Sensorsignal zu wandeln, welches in der Steuereinheit 12 zur Steuerung der Abgabe von Zubereitung verwendet wird.

Das piezoelektrische Element 6 kann in beiden beschriebenen Varianten des Weiteren als Schallwandler betrieben werden, indem es von der Steuereinheit 12 mit elektrischen Signalen beaufschlagt wird und die das piezoelektrische Element 6 in hörbare akustische Signale in einem Frequenzbereich von 20 Hz bis 20 kHz, bevorzugt 5 - 15 kHz, insbesondere bevorzugt 7 - 10 kHz wandelt.

Das piezoelektrische Element 6 ist, wie aus Fig. 1 gut zu erkennen ist, am frei beweglichen, distalen Ende des an der Toiletteninnenseite verlaufenden vertikalen Schenkels des Bügels 5 angeordnet. Hierdurch erfährt das piezoelektrische Element eine möglichst große Schwingungsamplitude, wodurch die Sensitivität der Sensoreinheit verbessert wird.

Das als Abgabeelement und Sensoreinheit konfigurierte piezoelektrische Element 6 ist mit der Steuereinheit 12 über eine Signal-/ Energieleitung 14 miteinander verbunden, so dass Steuersignale an bzw. vom piezoelektrischen Element 6 übertragen werden. Die hierzu benötigte elektrische Energie wird von einer im Dosiergerät 2 angeordneten Batterie 13 oder einem Akkumulator geliefert.

Der Bügel 5 ist insbesondere formstabil ausgebildet, so dass die Leitung 9 und/oder die Signal-/Energieleitung 14, die bevorzugt innerhalb des Bügels 5 verlaufen, vor mechanischen Einflüssen geschützt sind. Es ist jedoch auch möglich die Leitung 9 und/oder die Signal-/Energieleitung 14 außerhalb des Bügels 5 anzuordnen.

Am an der Toiletteninnenseite verlaufenden vertikalen Schenkel des Bügels 5 ist ferner ein als Feder ausgebildetes Befestigungsmittel 10 angeordnet. Die Feder 10 weist eine im Wesentlichen V-förmige Ausgestaltung auf, wobei ein Schenkel der V-förmigen Feder 10 fest am Bügel 5 angeordnet ist, während der freie Schenkel der V-förmigen Feder 10 gegen die Innenseitige Oberfläche des Toilettenbeckens 8 drückt. Hierdurch wird zum einen eine lösbare Fixierung des WC-Spülers 1 am Toilettenbecken 8 bewirkt, zum anderen werden Vibrationen und/oder Körperschall vom Toilettenbecken 8 auf den WC-Spüler und insbesondere auf das piezoelektrische Element 6 übertragen.

## Patentansprüche

1. Abgabevorrichtung (1) zur Abgabe einer fließfähigen Zubereitung, insbesondere ein WC-Spüler zur Befestigung am Rand einer Toilette, umfassend
eine elektrische Energiequelle (13),
eine Steuereinheit (12), die mit der Energiequelle , einer Sensoreinheit, einem Abgabeelement und einem Schallwandler verbunden ist, wobei
o die Sensoreinheit ein piezoelektrisches Element (6) ist, das geeignet ist Schwingungen, insbesondere Schallwellen in einem Frequenzbereich von 1 kHz - 300 kHz und/oder Körperschall aus der Umgebung der Abgabevorrichtung aufzunehmen und in ein Sensorsignal zu wandeln, welches in der Steuereinheit (12) in ein Steuersignal, insbesondere für das Abgabeelement, gewandelt wird,
o das Abgabeelement durch das piezoelektrische Element (6) ausgebildet ist, dass von der Steuereinheit (12) mit elektrischen Signalen beaufschlagt wird und wenigstens eine erste Zubereitung aus wenigstens einem ersten Behälter, der kommunizierend mit dem Abgabeelement verbunden ist, versprüht,
○ der Schallwandler durch das piezoelektrische Element (6) ausgebildet ist, dass von der Steuereinheit (12) mit elektrischen Signalen beaufschlagt wird und die das piezoelektrische Element in hörbare akustische Signale in einem Frequenzbereich von 20 Hz bis 20 kHz, bevorzugt 5 - 15 kHz, insbesondere bevorzugt 7 - 10 kHz wandelt,
wobei die Sensoreinheit, das Abgabeelement und der Schallwandler als ein Bauteil ausgebildet sind.

2. Abgabevorrichtung nach einem der vorherigen Ansprüche, **dadurch gekennzeichnet, dass** die elektrischen Signalen, die das Versprühen einer Zubereitung bewirken, eine Frequenz von 70 - 400 kHz, bevorzugt 80 - 90 kHz aufweisen und die elektrischen Signale, die die Erzeugung eines hörbaren akustischen Signals bewirken eine Frequenz von 20 Hz - 20 kHz , bevorzugt 5 - 15 kHz und insbesondere bevorzugt 7 - 10 kHz aufweisen.

3. Abgabevorrichtung nach einem der vorherigen Ansprüche, **dadurch gekennzeichnet, dass** das piezoelektrische Element (6) mit den elektrischen Signalen, die das Versprühen einer Zubereitung bewirken und den elektrischen Signalen, die die Erzeugung eines hörbaren akustischen Signals bewirken, durch die Steuereinheit (12) zeitgleich und/oder zeitversetzt beaufschlagt wird.

4. Abgabevorrichtung nach einem der vorherigen Ansprüche, **dadurch gekennzeichnet, dass** die Zubereitung wenigstens ein Tensid enthält.

5. Verwendung einer Abgabevorrichtung nach einem der vorherigen Ansprüche als WC-Spüler.

6. Verwendung einer Abgabevorrichtung nach einem der vorherigen Ansprüche zur Dosierung von Zubereitung in einer Wasch- und/oder Geschirrspülmaschine.

7. Verfahren zum Betrieb einer Abgabevorrichtung insbesondere nach einem der Ansprüche 1-4, **dadurch gekennzeichnet, dass** ,
a. eine Sensoreinheit, die ein piezoelektrisches Element (6) ist, Schwingungen, insbesondere Schallwellen in einem Frequenzbereich von 1 kHz - 300 kHz und/oder Körperschall aus der Umgebung der Abgabevorrichtung aufnimmt und in ein Sensorsignal wandelt,
b. ein Abgabeelement, dass durch das piezoelektrisches Element (6) ausgebildet ist, von einer Steuereinheit (12) beim Vorliegen eines definierten Sensorsignals mit elektrischen Signalen beaufschlagt wird, so dass wenigstens eine erste Zubereitung aus wenigstens einem ersten Behälter, der kommunizierend mit dem Abgabeelement verbunden ist, versprüht und/oder vernebelt wird,
c. ein Schallwandler, der durch das piezoelektrisches Element (6) ausgebildet ist, von der Steuereinheit (12) vor und/oder während und/oder nach dem Versprühen der Zubereitung mit elektrischen Signalen beaufschlagt wird, die das piezoelektrische Element in hörbare akustische Signale in einem Frequenzbereich von 20 Hz bis 20 kHz, bevorzugt 5 - 15 kHz, insbesondere bevorzugt 7 - 10 kHz wandelt.

## Claims

1. A release device (1) for releasing a flowable preparation, in particular a toilet freshener for fastening to the rim of a toilet, comprising an electrical energy source (13),
a control unit (12), which is connected to the energy source, a sensor unit, a release element and an acoustic transducer, in which
○ the sensor unit is a piezoelectric element (6), which is suitable for picking up oscillations, in particular sound waves in a frequency range of 1 kHz-300 kHz and/or structure-borne noise from the surrounding environment of the release device and converting them into a sensor signal, which is converted in the control unit (12) into a control signal, in particular for the release element,
○ the release element is constructed by the piezoelectric element (6), which is supplied with electrical signals from the control unit (12) and sprays at least one first preparation from at least one first container which is connected in communicating manner with the release element,
○ the acoustic transducer is constructed by the piezoelectric element (6), which is supplied with electrical signals from the control unit (12), which electrical signals are converted by the piezoelectric element into audible acoustic signals in a frequency range of 20 Hz to 20 kHz, preferably of 5-15 kHz, particularly preferably of 7-10 kHz,
wherein the sensor unit, the release element and the acoustic transducer are constructed as a single component.

2. The release device according to any one of the preceding claims, **characterized in that** the electrical signals, which bring about spraying of a preparation, have a frequency of 70-400 kHz, preferably of 80-90 kHz, and the electrical signals which bring about the generation of an audible acoustic signal have a frequency of 20 Hz-20 kHz, preferably of 5-15 kHz and particularly preferably of 7-10 kHz.

3. The release device according to either one of the preceding claims, **characterized in that** the piezoelectric element (6) is supplied by the control unit (12) simultaneously and/or with a time delay with the electrical signals, which bring about spraying of a preparation, and with the electrical signals, which bring about the generation of an audible acoustic signal.

4. The release device according to any one of the preceding claims, **characterized in that** the preparation contains at least one surfactant.

5. Use of a release device according to any one of the preceding claims as a toilet freshener.

6. Use of a release device according to any one of the preceding claims for dispensing preparation into a washing and/or dishwashing machine.

7. A method for operating a release device in particular according to any one of claims 1-4, **characterized in that**
a. a sensor unit, which is a piezoelectric element (6), picks up oscillations, in particular sound waves in a frequency range of 1 kHz-300 kHz and/or structure-borne noise from the surrounding environment of the release device and converts them into a sensor signal,
b. a release element, which is constructed by the piezoelectric element (6), is supplied with electrical signals from a control unit (12) in the presence of a defined sensor signal, such that at least one first preparation is sprayed and/or atomized from at least one first container which is connected in communicating manner with the release element,
c. an acoustic transducer, which is constructed by the piezoelectric element (6), is supplied with electrical signals from a control unit (12) before and/or during and/or after spraying of the preparation, which electrical signals are converted by the piezoelectric element into audible acoustic signals in a frequency range of 20 Hz to 20 kHz, preferably of 5-15 kHz, particularly preferably of 7-10 kHz.

## Revendications

1. Dispositif de distribution (1) pour la distribution d'une préparation à écoulement libre, en particulier un dispositif de rinçage pour W-C destiné à venir se fixer au bord d'une toilette, comprenant
- une source d'énergie électrique (13) ;
- une unité de commande (12) qui est reliée à la source d'énergie, à une unité de détection, à un élément de distribution et à un transducteur acoustique,
- l'unité de détection représentant un élément piézo-électrique (6) qui est approprié pour absorber des oscillations, en particulier des ondes sonores dans la plage de fréquences de 1 kHz à 300 kHz et/ou des bruits de structure à partir de l'environnement du dispositif de distribution, et pour les transformer en un signal de détection qui est transformé dans l'unité de commande (12) en un signal de commande, en particulier pour l'élément de distribution ;
- l'élément de distribution étant réalisé via l'élément piézo-électrique (6) qui est sollicité par l'unité de commande (12) avec des signaux électriques qui pulvérisent au moins une première préparation à partir d'au moins un premier récipient qui est mis en communication avec l'élément de distribution ;
- le transducteur acoustique étant réalisé via l'élément piézo-électrique (6) qui est sollicité avec des signaux électriques par l'unité de commande (12) qui sont transformés par l'élément piézo-électrique en signaux acoustiques audibles dans une plage de fréquences de 20 Hz à 20 kHz, de préférence de 5 à 15 kHz, de manière particulièrement préférée de 7 à 10 kHz ;
l'unité de détection, l'élément de distribution et le transducteur acoustique étant réalisés en une seule pièce.

2. Dispositif de distribution selon l'une quelconque des revendications précédentes, **caractérisé en ce que** les signaux électriques qui entraînent la pulvérisation d'une préparation présentent une fréquence de 70 à 400 kHz, de préférence de 80 à 90 kHz et les signaux électriques qui entraînent la production d'un signal acoustique audible présentent une fréquence de 20 Hz à 20 kHz, de préférence de 5 à 15 kHz et de manière particulièrement préférée de 7 à 10 kHz.

3. Dispositif de distribution selon l'une quelconque des revendications précédentes, **caractérisé en ce que** l'élément piézo-électrique (6) est sollicité avec des signaux électriques qui entraînent la pulvérisation d'une préparation, et des signaux électriques, qui entraînent la production d'un signal acoustique audible, par l'unité de commande (12) dans le même temps et/ou avec un certain décalage dans le temps.

4. Dispositif de distribution selon l'une quelconque des revendications précédentes, **caractérisé en ce que** la préparation contient au moins un agent tensioactif.

5. Utilisation d'un dispositif de distribution selon l'une quelconque des revendications précédentes, à titre d'agent de rinçage pour un W-C.

6. Utilisation d'un dispositif de distribution selon l'une quelconque des revendications précédentes, pour le dosage d'une préparation dans un lave-linge et/ou dans un lave-vaisselle.

7. Procédé pour la mise en service d'un dispositif de distribution en particulier selon l'une quelconque des revendications 1 à 4, **caractérisé en ce que** :
a. une unité de détection, qui représente un élément piézo-électrique (6), absorbe des oscillations, en particulier des ondes sonores dans la plage de fréquences de 1 kHz à 300 kHz et/ou des bruits de structure à partir de l'environnement du dispositif de distribution et les transforme en un signal de détection ;
b. un élément de distribution, qui est réalisé via l'élément piézo-électrique (6), est sollicité par une unité de commande (12), en présence d'un signal de détection défini, avec des signaux électriques, de telle sorte qu'au moins une première préparation à partir d'au moins un premier récipient, qui est mis en communication avec l'élément de distribution, est pulvérisée et/ou atomisée ;
c. un transducteur acoustique, qui est réalisé via l'élément piézo-électrique (6), est sollicité par l'unité de commande (12) avant et/ou pendant et/ou après la pulvérisation de la préparation avec des signaux électriques qui sont transformés par l'élément piézo-électrique en signaux acoustiques audibles dans une plage de fréquences de 20 Hz à 20 kHz, de préférence de 5 à 15 kHz, de manière particulièrement préférée de 7 à 10 kHz.
